# EUROPEAN PATENT APPLICATION

(11) **EP 2 075 119 A1**
(43) Date of publication of application: **01.07.2009**
(21) Application number: 07830071.2
(22) Date of filing: 18.10.2007
(51) Int. Cl.: B32B 5/02, B32B 27/18, D06M 11/83, D06M 15/263, D06M 15/564, H05K 9/00

(54) **FLAME-RETARDANT METAL-COATED FABRIC**

(30) Priority: 20.10.2006 JP 2006286733
(71) Applicant: SEIREN CO., LTD., Fukui-shi Fukui 918-8560 (JP)
(72) Inventor: SAKAGAWA, Sachiyo, Fukui-shi Fukui 918-8560 (JP); TAKEGAWA, Toru, Fukui-shi Fukui 918-8560 (JP)
(74) Representative: Treeby, Philip David William
(86) International application number: PCT/JP2007/070337
(87) International publication number: WO 2008/047861

(57) **Abstract**

A flame retardant metal-coated cloth having both high flame retardancy and flexible texture is provided. A film of a filler resin (A) is formed on at least one surface of a metal-coated cloth, and a flame retardant film of a mixed resin of a flame retardant (B) and a thermoplastic resin (C) is formed on one of the surfaces thereof. As the filler resin (A) and the thermoplastic resin (C), at least one selected from the group consisting of an acrylate resin, a urethane resin and a polyester resin can be used, and as the flame retardant (B), at least one selected from the group consisting of a bromine compound, a phosphorous compound and an antimony compound can be used.

## Description

### Technical Field

The present invention relates to a metal-coated cloth used as an electromagnetic wave shielding material for shielding from electromagnetic waves generated from electronic equipment and for countermeasure against static electricity, and more specifically, relates to a metal-coated cloth having both high flame retardancy and flexible texture.

### Background Art

In recent years, associated with rapid diffusion of electronic equipment into all fields including home and office, there arises a problem in electromagnetic wave hazard, in which equipment suffer malfunction due to electromagnetic waves leaked from other electronic equipment. Various electromagnetic wave shielding materials have been used for avoiding the problem.

According to enforcement of the Product Liability Law (PL Law), flame retardancy is demanded not only in electronic equipment but also in electromagnetic wave shielding materials, and in particular, there is a strong demand for flame retardancy that satisfies the FMVSS Standard and the UL Standard.

Examples of an electromagnetic wave shielding material include a fiber cloth having a metal coated on the surface of fibers, but the material is often increased in combustibility due to the coated metal functioning as an oxidation catalyst. It is considered that this is because the coated metal not only impairs the extinction function by melting the fibers, but also increases the thermal conductivity of the fibers to assist spread of fire. Various investigations have been made for improving the flame retardancy of those materials.

Patent Document 1 discloses a metal-coated fiber fabric containing a metal-coated fiber fabric having coated on the surface thereof a urethane resin, having coated on the surface thereof a mixture of an organic compound flame proofing agent, such as an organic phosphorous compound, and an inorganic compound flame proofing assistant, such as an antimony compound, and having further coated on the surface thereof a urethane resin, thereby attaining flame proofing property and anti-rusting property. Patent Document 2 discloses provision of a flame retardant EMI shielding material by adding a curing layer of a flame retardant composition to at least a part of a porous base material having electroconductivity under a rheological pressure and a viscosity having been determined in advance.

The metal-coated cloth obtained in Patent Document 1, however, is difficult to provide high flame retardancy demanded for electronic equipments as the FMVSS and UL Standards. If a large amount of the flame retarding compound is applied for improving the flame retardancy, the electroconductivity on the surface is lost to fail to function as an electromagnetic wave shielding material, and the texture of the cloth is stiffened to lose flexibility, which brings about a problem upon using as an electromagnetic wave shielding gasket. In Patent Document 2, even if the curing layer of a flame retardant composition is controlled to have a limit of permeation depth that is less than the thickness of the base material, the structure of the base material is fixed by permeation into the pores, which brings about a problem of stiff texture.
Patent Document 1: JP-A-7-42079
Patent Document 2: JP-T-2002-505528

### Disclosure of the Invention

### Problems to be solved by the Invention

The invention has been made in view of the circumstances, and an object thereof is to provide such a flame retardant metal-coated cloth that has high flame retardancy and also has flexible texture.

### Means for solving the Problems

As a result of earnest investigations made by the inventors for solving the problems, it has been found that a flame retardant metal-coated cloth having both high flame retardancy and flexible texture can be obtained by forming a film of a filler resin (A) on at least one surface of a metal-coated cloth, and forming a resin film of a mixture of a flame retardant (B) and a thermoplastic resin (C) further on at least one surface thereof, thereby attaining the invention based on the findings.

Accordingly, the invention relates to a flame retardant metal-coated cloth characterized by containing a film of a filler resin (A) formed on at least one surface of a metal-coated cloth, and a film of a mixture of a flame retardant (B) and a thermoplastic resin (C) formed further on one of the surfaces thereof.

### Advantage of the Invention

According to the invention, a metal-coated cloth having both high flame retardancy and flexible texture can be provided. The flame retardant metal-coated cloth of the invention has a filler resin film (A) on at least one surface in advance, whereby upon forming a resin of a mixture of a flame retardant (B) and a thermoplastic resin (C), the resin is prevented from being leaked from gaps among the fibers. The mixed resin of the flame retardant (B) and the thermoplastic resin (C) can be formed with a low viscosity when the resin is not leaked, and thus, a flexible flame retardant metal-coated cloth can be obtained. That is, a flexible shielding gasket can be obtained. Furthermore, upon producing a shielding gasket, there is no possibility where a wet resin is attached to a working machine. The flame retardant metal-coated cloth of the invention has flame retardancy without severe deterioration in flexibility inherent to the cloth, electroconductivity inherent to the metal, and electromagnetic wave shielding property inherent to the metal-coated cloth, and therefore, can be favorably used as an electromagnetic wave shielding material.

### Best Mode for carrying out the Invention

The invention will be described in detail below.

Examples of the cloth used in the invention include those in the form of a woven cloth, a knitted cloth and a nonwoven cloth without particular limitation. Examples of the fiber material used include synthetic fibers, such as a polyester series (e.g., polyethylene terephthalate and polybutylene terephthalate), a polyamide series (e.g., nylon 6 and nylon 66), a polyolefin series (e.g., polyethylene and polypropylene), a polyacrylonitrile series, a polyvinyl alcohol series and a polyurethane series, semisynthetic fibers, such as a cellulose series (e.g., diacetate and triacetate) and a protein series (e.g., promix), regenerated fibers, such as a cellulose series (e.g., rayon and cupra) and a protein series (e.g., casein fibers), and natural fibers, such as a cellulose series (e.g., cotton and hemp) and a protein series (e.g., wool and silk), which may be used in combination of two or more kinds of them. Among these, taking processability and durability into consideration, synthetic fibers are preferred, and polyester series fibers are more preferred.

The fiber surface of the cloth formed of the aforementioned fibers can be coated with a metal by a known method, such as a vapor deposition method, a sputtering method, an electroplating method and an electroless plating method. Among these, taking the uniformity of a metallic film formed and the productivity into consideration, an electroless plating method and combination use of an electroless plating method and an electroplating method are preferred. For ensuring fixation of the metal, it is preferred that impurities, such as a glue material, an oily material and dusts, are completely removed by a refining treatment. The refining treatment may be a known method and is not particularly limited.

Examples of the metal used include gold, silver, copper, zinc, nickel and alloys of them, and taking electroconductivity and production cost into consideration, copper and nickel are preferred. The film formed with the metal preferably includes one layer or two layers. In the case of three or more layers, the thickness of the metallic film is increased, and it is not preferred since not only the texture of the cloth is stiffened, but also the production cost is increased. In the case where the metallic film contains two layers accumulated, the same metal may be accumulated as two layers, or different metals may be accumulated. These may be appropriately determined taking the demanded electromagnetic wave shielding property and durability into consideration.

The flame retardant metal-coated cloth of the invention is characterized by containing a film of a filler resin (A) formed on at least one surface of the aforementioned metal-coated cloth, and a film of a mixture of a flame retardant (B) and a thermoplastic resin (C) formed further on one of the surfaces thereof.

Examples of the filler resin (A) used in the invention include a urethane resin, an acrylate resin and a polyester resin, which may be used in combination of two or more of them. Among these, taking flexibility into consideration, a urethane resin and an acrylate resin are preferred, and an acrylate resin is more preferred. An acrylate resin is particularly preferably used in the invention since it generally has flexible texture, is excellent in processability and is economically low in cost. The filler resin (A) is formed on at least one surface of the metal-coated cloth, and in the case where it is formed on the same surface as the mixed resin layer of the flame retardant (B) and the thermoplastic resin (C), the film is formed within gaps of the cloth to attain an effect of preventing the mixed resin from being leaked to the back surface. In the case where the filler resin (A) is formed on the opposite surface to the mixed resin layer, not only the prevention of leakage of the mixed resin to the back surface, but also prevention of soiling by handling and countermeasure against metal allergy can be expected. In the case where the filler resin (A) is formed on both surfaces, the surfaces of the metal-coated cloth are smoothened in addition to the aforementioned advantages, whereby air bubbles can be prevented from being formed on the surface of the mixed resin. Upon taking durability of the filler resin (A) and adhesiveness thereof to the flame retardant (B) and the thermoplastic resin (C) into consideration, a crosslinking agent, such as isocyanate and melamine, may be added. A flame retarding assistant may be added for further improving the flame retardancy, and a pigment may be added for artistry.

Examples of the flame retardant (B) used in the invention include a bromine compound, a phosphorous compound and an antimony compound.

Specific examples of the bromine compound include known compounds, such as tetrabromobisphenol A, hexabromocyclododecane and ethylene bispolybromodiphenyl, which may be used in combination of two or more of them.

Specific examples of the phosphorous compound include known compounds, such as a phosphazene compound, melamine polyphosphate and ammonium polyphosphate, which may be used in combination of two or more of them.

Specific examples of the antimony compound include known compounds, such as antimony trioxide and antimony pentoxide.

It has been known in general that the combination of use of two or more among the bromine compounds, the phosphorous compounds and the antimony compounds described above exhibits synergistic effect as compared to the use of one of them, and thus the combination use is more preferred.

The thermoplastic resin (C) is used in the invention for the purpose of fixing the flame retardant (B) to the metal-coated cloth, i.e., as a binder resin. Examples of the thermoplastic resin (C) used for the purpose include a urethane resin, an acrylate resin and a polyester resin, which may be used in combination of two or more of them. Among these, taking flexibility into consideration, a urethane resin and an acrylate resin are preferred, and a urethane resin is more preferred. A urethane resin is particularly preferably used in the invention since it is hard to damage the flame retardancy and has flexible texture.

The mixing ratio of the flame retardant (B) and the thermoplastic resin (C) is preferably from 140/100 to 570/100 in solid basis, and taking flexibility into consideration, is more preferably from 230/100 to 370/100. In the case where the amount of the flame retardant is less than the range, high flame retarding effect cannot be obtained, and in the case where it is too large, stiff texture is obtained, which is not suitable for a shielding gasket.

The mixture of the flame retardant (B) and the thermoplastic resin (C) may be mixed with other additives for such purposes as coloration, control of texture, application of function, e.g., insulating property, and further improvement in flame retardancy, in such a range that does not impair the capability of the mixture. Examples of the additives include an elastomer, such as silicone rubber, olefin copolymer, modified nitrile rubber and modified polybutadiene rubber, a thermoplastic resin, such as polyethylene, a flame retarding assistant, such as expansive graphite, melamine and melamine cyanurate, and a pigment.

The raw materials used in the invention including the filler resin (A), the flame retardant (B), the thermoplastic resin (C) and the additives may be commercially available products without particular limitation. For example, the filler resin (A) is commercially available in the form of a solution in an organic solvent, which can be easily procured.

The flame retardant metal-coated cloth of the invention can be produced by coating the filler resin (A), the flame retardant (B) and the thermoplastic resin (C) having been described above as the essential components on the metal-coated cloth to form a flame retardant film of the mixture of the flame retardant (B) and the thermoplastic resin (C).

Examples of a solvent for dissolving or dispersing the raw materials include an organic solvent, such as benzene, toluene, xylene, methyl ethyl ketone and dimethylformamide. Distilled fractions of mineral oil, such as industrial gasoline, petroleum naphtha and turpentine oil, may also be used. These may be used in combination of two or more of them.

The filler resin (A) is preferably adjusted to exhibit a viscosity of from 5, 000 to 30, 000 cps by adding an appropriate amount of solvent. In the case where the viscosity of the filler resin (A) is less than 5,000 cps, a film of the filler resin is hard to be formed in gaps of the cloth, and as a result, the mixed resin of the flame retardant (B) and the thermoplastic resin (C) is leaked to the back surface to fail to attain the filler effect, which may bring about deterioration in appearance quality. In the case where the viscosity exceeds 30,000 cps, on the other hand, the coating workability is deteriorated.

The mixed resin of the flame retardant (B) and the thermoplastic resin (C) is preferably adjusted to exhibit a viscosity of from 3, 000 to 25, 000 cps by adding an appropriate amount of solvent. In the case where the viscosity of the mixed resin is less than 3,000 cps, it is uneconomical due to excessive use of the solvent, and a prolonged period of time is required for drying to deteriorate productivity. In the case where the viscosity exceeds 25, 000 cps, on the other hand, the coating workability is deteriorated.

The filler resin (A) or the mixed resin of the flame retardant (B) and the thermoplastic resin (C) may be prepared by any method as far as the raw materials can be uniformly mixed and dispersed. Examples of the general method include mixing and dispersing by agitation with propellers, and mixing and dispersing by kneading with a kneader, a roller or the like.

As a coating method, an ordinary method may be employed using a knife coater, a roll coater, a slit coater or the like. A laminating method and a bonding method may also be employed. After coating the filler resin (A) on at least one surface of the metal-coated cloth, the solvent is removed by drying or the like, and then the mixed resin of the flame retardant (B) and the thermoplastic resin (C) is coated on one of the surfaces thereof, followed by removing the solvent by drying or the like, to form the flame retardant film.

The applied amount of the filler resin (A) with respect to the metal-coated cloth is desirably from 3 to 50% by weight. In the case where the applied amount is less than 3% by weight, sufficient filling effect may not be obtained, and leakage of the flame retardant (B) and the thermoplastic resin (C) to the back surface may occur. In the case where it exceeds 50% by weight, it is not preferred since the texture may be stiffened. The applied amount of the mixed resin of the flame retardant (B) and the thermoplastic resin (C) with respect to the metal-coated cloth is preferably from 50 to 300% by weight. In the case where the applied amount is less than 50% by weight, high flame retardancy may not be obtained, and in the case where it exceeds 300% by weight, not only flexibility inherent to the cloth is lost, but also further improvement in flame retardancy cannot be expected.

The thickness of the filler resin is preferably from 3 to 30 µm at the gaps of the cloth. In the case where the thickness is less than 3 µm, the mixed resin may be leaked to the back surface, and in the case where the thickness exceeds 30 µm, the flexibility is impaired to deteriorate the handleability.

The thickness of the flame retardant metal-coated cloth is preferably from 50 to 400 µm. In the case where it is less than 50 µm, the processability is deteriorated, and in the case where it exceeds 400 µm, the flame retardant metal-coated cloth loses flexibility, which is not suitable for a shielding gasket material.

After forming the flame retardant film, a process for applying other functions, such as application of an adhesive and lamination of a film, and a special process, such as a calendering process, may be carried out. **Example**

The invention will be described in more detail with reference to the examples below, but the invention is not limited to the examples below. The "parts" and "%" in the examples are weight basis. The capabilities of the resulting flame retardant metal-coated cloths were evaluated in the following manner.

### (1) Flame Retardancy

It was in accordance with the UL94 Method, VTM-0 Test Method.

### (2) Leakage to Back Surface

In the case where the mixed resin of the flame retardant (B) and the thermoplastic resin (C) is observed through gaps of the cloth on viewing from the opposite surface to the surface having the mixed resin applied thereto, it is determined that the leakage to the back surface is "present".

### (3) Stiffness and Flexibility

It was in accordance with JIS L 1096A Method (45° cantilever method). A smaller value thereof means more flexible texture.

### (4) Surface Conductivity

The resistance of the surface of the sample was measured by using a resistance measuring device, Loresta-EP MCP-T360 ESP Type, produced by Mitsubishi Chemical Corp.

### (5) Electromagnetic Wave Shielding Property

The attenuation of electromagnetic waves of from 10 MHz to 1 GHz was measured according to the KEC Method by Kansai Electronic Industry Development Center by using a spectrum analyzer equipped with a tracking generator, HP8591EM, produced by Hewlett-Packard Japan, Ltd.

### [Example 1]

A polyester fiber woven cloth (warp yarn: 56 dtex/36 f, weft yarn: 56 dtex/36 f) was refined, dried and heat-treated, and then immersed in an aqueous solution containing 0.3 g/L of palladium chloride, 30 g/L of stannous chloride and 300 ml/L of 36% hydrochloric acid at 40°C for 2 minutes, followed by rinsing with water. Subsequently, it was immersed in hydrofluoroboric acid having an acid concentration of 0.1 N at 30°C for 5 minutes, followed by rinsing with water. It was then immersed in an electroless copper plating solution containing 7.5 g/L of copper sulfate, 30 ml/L of 37% formalin and 85 g/L of Rochelle salt at 30°C for 5 minutes, followed by rinsing with water. Subsequently, it was immersed in a nickel electroplating solution containing 300 g/L of nickel sulfamate, 30 g/L of boric acid and 15 g/L of nickel chloride at pH 3.7 and 35°C for 10 minutes under a current density of 5 A/dm² to accumulate nickel, followed by rinsing with water. The cloth was plated with 10 g/m² of copper and 4 g/m² of nickel. The basis weight of the resulting metal-coated cloth was 64 g/m².

A filling resin having Formulation 1 below was coated on one surface of the resulting metal-coated cloth by using a knife, followed by drying at 130°C for 1 minute. The applied amount was 4 g/m² on solid basis. A mixed resin having Formulation 2 below was coated on the same surface by using a knife, followed by drying at 130°C for 2 minutes. The applied amount was 80 g/m² on solid basis.

| (Formulation 1) | |
|---|---|
| Toacron SA-6218 | 100 parts |
| (acrylate resin, produced by Tohpe Co., Ltd., solid content: 18%) Leathermin UD Crosslinking Agent | 1.5 parts |
| (isocyanate crosslinking agent, produced by Dainichiseika | |
| Color & Chemicals Mfg. Co., Ltd., solid content: 75%) Toluene | adequate amount |

The viscosity was controlled to 15, 000 cps by adjusting the addition amount of toluene.

| (Formulation 2) | |
|---|---|
| Leathermin ME3612LP | 100 parts |
| (urethane resin, produced by Dainichiseika Color & Chemicals Mfg. Co., Ltd., solid content: 30%) | |
| Vigol Bui-854 | 120 parts |
| (flame retardant, produced by Daikyo Chemical Co., Ltd., solid content: 85%) | |
| Methyl ethyl ketone | adequate amount |

The viscosity was controlled to 8,500 cps by adjusting the addition amount of methyl ethyl ketone.

### [Example 2]

The filling resin having Formulation 1 was coated by using a knife on one surface of a metal-coated cloth plated in the same manner as in Example 1, followed by drying at 130°C for 1 minute. The applied amount was 4 g/m² on solid basis. The mixed resin having Formulation 2 was coated on the other surface by using a knife, followed by drying at 130°C for 2 minutes. The applied amount was 90 g/m² on solid basis.

### [Example 3]

The filling resin having Formulation 1 was coated by using a knife on one surface of a metal-coated cloth plated in the same manner as in Example 1, followed by drying at 130°C for 1 minute. The filling resin having Formulation 1 was coated by using a knife on the other surface, followed by drying at 130°C for 1 minute. The applied amount of the filling resin coated on both surfaces was 8 g/m² on solid basis. The mixed treating solution having Formulation 2 was coated on one of the surfaces by using a knife, followed by drying at 130°C for 2 minutes. The applied amount was 80 g/m² on solid basis.

### [Example 4]

A filling resin having Formulation 3 was coated by using a knife on one surface of a metal-coated cloth plated in the same manner as in Example 1, followed by drying at 130°C for 1 minute. The mixed treating solution having Formulation 2 was coated on the other surface by using a knife, followed by drying at 130°C for 2 minutes. The applied amount was 80 g/m² on solid basis.

| (Formulation 3) | |
|---|---|
| Crisvon 2116EL | 100 parts |
| (polyurethane resin, produced by Dainippon Ink And Chemicals, Inc., solid content: 30%) | |
| Leathermin UD Crosslinking Agent | 1.5 parts |
| (isocyanate crosslinking agent, produced by Dainichiseika Color & Chemicals Mfg. Co., Ltd., solid content: 75%) | |
| Dimethylformamide | adequate amount |

The viscosity was controlled to 15, 000 cps by adjusting the addition amount of dimethylformamide.

### [Comparative Example 1]

The mixed resin having Formulation 2 was coated by using a knife on one surface of a metal-coated cloth plated in the same manner as in Example 1, followed by drying at 130°C for 2 minutes. The applied amount was 80 g/m² on solid basis.

The evaluation results of Examples and Comparative Example are shown in Table 1. In the column of Resin in Table 1, "AC" means that a film of the acrylate resin is formed, "PU" means that a film of the urethane resin is formed, "FR" means that a film of the mixed resin of the flame retardant and the thermoplastic resin is formed, and "AC -> FR" means that a film of the acrylate resin is formed, on which a film of the mixed resin of the flame retardant and the thermoplastic resin is formed. One of the terms "Front" and "Back" is used for one surface with the other being used for the other surface for descriptive purposes, and the terms do not necessarily mean the front and back surfaces upon using the resulting flame retardant metal-coated cloth.

**[Table 1]**

| | Flame retardancy | Leakage to back surface | Stiffness and flexibility (mm) | Surface conductivity Ω/square warp/weft | Electromagnetic wave shielding property (dB) | | Resin | |
|---|---|---|---|---|---|---|---|---|
| | | | | | 10 MHz | 1 GHz | Front | Back |
| Example 1 | passed | none | 48 | 0.05/0.05 | 98 | 80 | none | AC -> FR |
| Example 2 | passed | none | 49 | 0.05/0.05 | 98 | 80 | AC | FR |
| Example 3 | passed | none | 49 | 0.05/0.05 | 98 | 80 | AC | AC -> FR |
| Example 4 | passed | none | 49 | 0.05/0.05 | 98 | 80 | PU | FR |
| Comparative Example 1 | passed | present | 65 | 0.05/0.05 | 98 | 80 | none | FR |

It was understood from Table 1 that flame retardant metal-coated cloths having both high flame retardancy and flexible texture were obtained according to Examples 1 to 4.

In Comparative Example 1 having no film of the filler resin formed, on the other hand, considerable leakage to the back surface was found with stiff texture, and it could not be subjected to practical use although the flame retardancy was satisfied.

## Claims

1. A flame retardant metal-coated cloth **characterized by** comprising a film of a filler resin (A) formed on at least one surface of a metal-coated cloth, and a film of a mixed resin of a flame retardant (B) and a thermoplastic resin (C) formed further on one of the surfaces thereof.

2. The flame retardant metal-coated cloth according to claim 1, **characterized in that** a film of a filler resin (A) is formed on one surface of a metal-coated cloth, and a film of a mixed resin of a flame retardant (B) and a thermoplastic resin (C) is formed further on the film.

3. The flame retardant metal-coated cloth according to claim 1, **characterized in that** the filler resin (A) is at least one selected from the group consisting of an acrylate resin, a urethane resin and a polyester resin.

4. The flame retardant metal-coated cloth according to claim 1, **characterized in that** the flame retardant (B) is at least one selected from the group consisting of a bromine compound, a phosphorous compound and an antimony compound.

5. The flame retardant metal-coated cloth according to claim 1, **characterized in that** the thermoplastic resin (C) is at least one selected from the group consisting of an acrylate resin, a urethane resin and a polyester resin.
